# EUROPÄISCHE PATENTSCHRIFT

(11) **EP 3 081 057 B1**
(45) Veröffentlichungstag und Bekanntmachung des Hinweises auf die Patenterteilung: **25.11.2020**
(21) Anmeldenummer: 14811773.2
(22) Anmeldetag: 09.12.2014
(51) Int. Cl.: H05K 3/02, G06K 19/077, B30B 5/06, B32B 15/14, B32B 15/20, B32B 37/10, B32B 38/06, H05K 1/03, H05K 3/00, H05K 3/40

(54) **VERFAHREN ZUM HERSTELLEN EINES MODULSTREIFENS**
METHOD FOR PRODUCING A MODULE STRIP
PROCÉDÉ PERMETTANT DE PRODUIRE UNE BANDE MODULAIRE

(30) Priorität: 09.12.2013 DE 102013020555
(43) Veröffentlichungstag der Anmeldung: 19.10.2016
(73) Patentinhaber: Giesecke+Devrient Mobile Security GmbH, 81677 München (DE)
(72) Erfinder: BALDISCHWEILER, Michael, 81825 München (DE)
(86) Internationale Anmeldenummer: PCT/EP2014/003291
(87) Internationale Veröffentlichungsnummer: WO 2015/086144

(56) Entgegenhaltungen:
- DE-A1- 3 811 467
- DE-A1-102012 003 603
- DE-C1- 19 939 347
- US-A- 4 557 778

## Beschreibung

Die vorliegende Erfindung betrifft ein Verfahren zum Herstellen eines Modulstreifens. Genauer betrifft die Erfindung die Herstellung eines Modulstreifens, der Erhebungen in einer auf einer Seite des Modulstreifens angeordneten, elektrisch leitfähigen Schicht aufweist.

Derartige Modulstreifen werden in bekannter Weise zur Herstellung von Chipmodulen verwendet, welche dann, in ebenfalls bekannter Weise, in Chipkarten und dergleichen eingesetzt werden können. Ein Modulstreifen umfasst in der Regel eine Trägerschicht, beispielsweise eine Kunststoffschicht, und zumindest auf einer Seite dieser Trägerschicht eine elektrisch leitfähige Schicht. Diese elektrisch leitfähige Schicht kann dann die genannten Erhebungen aufweisen, welche beispielsweise dazu dienen können, das Chipmodul elektrisch leitfähig mit einer in einer Chipkarte integrierten Antenne oder anderen elektronischen Bauelementen zu verbinden. Eine weitere, auf der gegenüberliegenden Seite der Trägerschicht angeordnete, elektrisch leitfähige Schicht kann ergänzend als Kontakt-Schnittstelle für ein kontaktbasiertes Lesegerät dienen.

Derzeit erfolgt die Herstellung der Erhebungen in der elektrisch leitfähigen Schicht in einem diskontinuierlichen Verfahren mittels einer Plattenpresse. Dabei werden in der auf der Trägerschicht angeordneten elektrisch leitfähigen Schicht im Rahmen eines Laminierprozesses mithilfe einer räumlich strukturierten Platte, beispielsweise einer Messingplatte, die Erhebungen ausgeformt. Ein derartiges Verfahren ist beispielsweise bereits aus der DE 10 2012 003603 A1 bekannt.

Die DE 3811467 A1 beschreibt ein Verfahren zur kontinuierlichen Herstellung von bahnförmigem Material für Leiterplatten. Bei diesem Verfahren wird eine Metallbahn zusammen mit einer Glasfaserbahn unter Einsatz von Druck und Wärme zu einer Doppelbahn stoffschlüssig vereinigt.

Aufgabe der vorliegenden Erfindung ist es demnach, ein Verfahren zum Herstellen von Modulstreifen der beschriebenen Art vorzuschlagen, welches als Endlosprozess, d.h. kontinuierlich, durchgeführt werden kann.

Diese Aufgabe wird durch ein Verfahren mit den Merkmalen des unabhängigen Patentanspruchs gelöst. Vorteilhafte Ausgestaltungen und Weiterbildungen sind in den abhängigen Patentansprüchen angegeben.

Die Erfindung basiert auf dem Grundgedanken, die Erhebungen in der elektrisch leitfähigen Schicht nicht mehr mittels einer strukturierten Platte zu erzeugen, sondern eine Matrizenfolie bereitzustellen, welche ein geeignetes räumliches Profil aufweist und welche hinsichtlich Material und Schichtdicke derart ausgebildet ist, dass sie einer Endloslaminierpresse zusammen mit der Trägerschicht und der zumindest einen elektrisch leitfähigen Schicht zugeführt werden kann.

Genauer umfasst eine bevorzugte Ausführungsform eines Verfahrens zum Herstellen eines Modulstreifens, insbesondere für die Chipmodulherstellung, mit Erhebungen in einer auf einer Seite des Modulstreifens angeordneten elektrisch leitfähigen Schicht die folgenden Schritte:
Zunächst werden eine Trägerschicht und zumindest eine elektrisch leitfähige Schicht bereitgestellt. Weiterhin wird eine räumlich strukturierte Matrizenfolie bereitgestellt. Die räumliche Strukturierung ist dadurch gegeben, dass die Matrizenfolie nachfolgend genauer spezifizierte Aussparungen aufweist.

In einem weiteren Schritt wird die Matrizenfolie zusammen mit der Trägerschicht und der elektrisch leitfähigen Schicht einer Endloslaminierpresse zugeführt. Die elektrisch leitfähige Schicht wird dabei zwischen der Matrizenfolie und der Trägerschicht angeordnet. Die Trägerschicht wird dabei mit der elektrisch leitfähigen Schicht - in der Regel unter Zufuhr von Wärme - in der Endloslaminierpresse in einem kontinuierlichen Prozess zu dem Modulstreifen verbunden. Dabei wird die elektrisch leitfähige Schicht durch den in der Endloslaminierpresse vorliegenden Druck in die Aussparungen der Matrizenfolie gepresst. Dadurch ergeben sich die gewünschten Erhebungen in der elektrisch leitfähigen Schicht.

Auf diese Weise kann ein herkömmlicher Endloslaminierprozess verwendet werden, um den Modulstreifen herzustellen und gleichzeitig die Erhebungen in der elektrisch leitfähigen Schicht zu erzeugen. Ein diskontinuierlicher Prozess unter Verwendung einer Prägeplatte oder dergleichen kann daher entfallen.

Die Matrizenfolie ist hinsichtlich ihres Materials und ihrer Schichtdicke derart ausgebildet und die Aussparungen sind derart dimensioniert, dass, wenn die Matrizenfolie zusammen mit der Trägerschicht und der elektrisch leitfähigen Schicht der Endloslaminierpresse zum Verbinden der Trägerschicht mit der elektrisch leitfähigen Schicht zu dem Modulstreifen in dem kontinuierlichen Prozess zugeführt und als äußere Lage benachbart zu der elektrisch leitfähigen Schicht angeordnet wird, sich in der elektrisch leitfähigen Schicht Erhebungen vorgegebener Dimension dadurch ergeben, dass die elektrisch leitfähige Schicht durch Druck in die Aussparungen der Matrizenfolie gepresst wird.

Die Matrizenfolie wird dabei vorzugsweise als Metallfolie ausgebildet, beispielsweise als Kupfer- oder Messingfolie.

Vorzugsweise werden die Trägerschicht und die elektrisch leitfähige Schicht der Endloslaminierpresse jeweils in Form eines Endlosbandes zugeführt. Ebenfalls bevorzugt ist es, die Matrizenfolie der Endloslaminierpresse in Form eines Endlosbandes zuzuführen. Da sich die Matrizenfolie im Rahmen des Laminierprozesses nicht mit der elektrisch leitfähigen Schicht verbindet, kann die Matrizenfolie am Ende des Prozesses beispielsweise wieder aufgerollt oder aufgewickelt und insbesondere auch wiederverwendet werden. Als Trägerschicht wird vorzugsweise eine Kunststoffschicht bereitgestellt, welche aus einem noch nicht vollständig ausgehärteten, insbesondere einem noch nicht vollständig vernetzten Kunststoff besteht.

Der Kunststoff kann dabei als faserverstärkter Kunststoff bereitgestellt werden. Solche Materialien sind unter dem Begriff "prepreg" ("preimpregnated fibres") bekannt.

Als elektrisch leitfähige Schicht wird vorzugsweise eine Kupferschicht bereitges tellt.

Wie bereits erwähnt, kann auch die Matrizenfolie in Form einer Metallfolie, insbesondere einer Kupfer- oder Messingfolie bereitgestellt werden.

Dabei weist die Matrizenfolie vorzugsweise eine Dicke von höchstens 150 µm auf. Durch die Dicke der Folie wird insbesondere auch die maximale Höhe der erzeugten Erhebungen vorgegebenen, da die Tiefe der Aussparungen in der Folie durch die maximale Dicke der Folie beschränkt ist. Erfindungsgemäß liegen die Aussparungen in der Folie als die Folie vollständig durchsetzende Durchgangslöcher vor.

Der Durchmesser der Aussparungen in der Matrizenfolie kann dabei - bei vorgegebenem Druck in der Endloslaminierpresse - ebenso die Höhe der entsprechenden Erhebungen, welche durch das Einpressen der elektrisch leitfähigen Schicht in die Aussparungen entstehen, mitbestimmen. Dies gilt, da bei gegebenem Druck ein größerer Durchmesser einer Aussparung dazu führen kann, dass die Schicht tiefer in die Aussparung eingepresst wird als dies bei einem geringeren Durchmesser der Aussparung der Fall wäre.

Vorzugsweise wird beim Einpressen der elektrisch leitfähigen Schicht in die Aussparungen der Matrizenfolie aus den Aussparungen entweichende Luft über mit den Aussparungen verbundene Entlüftungskanäle der Matrizenfolie abgeleitet. Die Entlüftungskanäle bilden dabei eine weitere räumliche Strukturierung der Matrizenfolie und sind in der Regel auf der Seite der Matrizenfolie ausgebildet, welche der Seite gegenüberliegt, die im Endloslaminierprozess an die elektrisch leitfähige Schicht das Modulstreifens angrenzt.

Vorzugsweise ist jede der Aussparungen der Matrizenfolie mit mindestens drei Entlüftungskanälen verbunden. Um eine sichere Entlüftung auch bei gegebenenfalls vorliegenden Materialstörungen in der Matrizenfolie zu gewährleisten, ist es bevorzugt, dass die Entlüftungskanäle untereinander verbunden sind. Beispielsweise können die Entlüftungskanäle gitterförmig oder schachbrettartig angeordnet sein.

Die Entlüftungskanäle können in der Matrizenfolie, genauso wie die vorstehend genannten Aussparungen, mittels bekannter Verfahren hergestellt werden. Bevorzugte Verfahren sind beispielsweise Ätzen, Fräsen, Lasern, etc.

Wie eingangs erwähnt, kann der Endloslaminierpresse eine weitere elektrisch leitfähige Schicht zugeführt werden. Die elektrisch leitfähige Schicht und die weitere elektrisch leitfähige Schicht werden dabei auf gegenüberliegenden Seiten der Trägerschicht angeordnet und verbinden sich beide mit der Trägerschicht zu dem Modulstreifen. Die elektrisch leitfähige Schicht mit den Erhebungen dient in der Regel dazu, eine elektrisch leitfähige Verbindung zu einer Leiterstruktur innerhalb einer Chipkarte oder dergleichen herzustellen, in welche ein aus dem Modulstreifen hergestelltes Chipmodul eingebettet wird, beispielsweise einer im Inneren einer Chipkarte angeordneten Antenne zur kontaktlosen Datenkommunikation. Im Gegensatz dazu dient die weitere elektrisch leitfähige Schicht, welche nach dem Einbetten des Chipmoduls in der Regel auf einer äußeren Oberfläche der Chipkarte frei zugänglich vorliegt, vorzugsweise als Kontaktfläche zur kontaktbehafteten Datenkommunikation mit einem Lesegerät.

Gemäß der Erfindung wird eine räumlich strukturierte Prägefolie bereitgestellt. Diese Prägefolie wird der Endloslaminierpresse zusammen mit der Matrizenfolie, der Trägerschicht und der zumindest einen elektrisch leitfähigen Schicht zugeführt. Die Prägefolie wird dabei als äußere Lage benachbart zu der Matrizenfolie angeordnet. Weiterhin ist die Prägefolie zumindest im Bereich der Aussparungen der Matrizenfolie derart räumlich strukturiert, dass der in die Aussparungen der Matrizenfolie eingepressten elektrisch leitfähigen Schicht - im Bereich der Spitzen der Erhebungen - eine räumliche Struktur durch die Prägefolie eingeprägt wird.

Eine solche räumliche Struktur in den Erhebungen dient dazu, eine Kontaktierung der Erhebungen zu einer entsprechenden elektrisch leitfähigen Schicht, beispielsweise einer Antenne, welche im Inneren eines Chipkartenkörpers angeordnet ist, zu verbessern, insbesondere aufgrund einer besseren Haftung zwischen Erhebung und Antenne aufgrund der eingeprägten Struktur.

Auch die Prägefolie wird vorzugsweise in Form einer Metallfolie, beispielsweise einer Kupfer- oder Messingfolie bereitgestellt.

Das beschriebene Verfahren wird vorzugsweise mittels eines Systems durchgeführt, welches eine Endloslaminierpresse sowie Vorrichtungen zum Zuführen der Trägerschicht und der zumindest einen elektrisch leitfähigen Schicht aufweist. Weiterhin umfasst das System eine Vorrichtung zum Zuführen der Matrizenfolie sowie gegebenenfalls eine Vorrichtung zum anschließenden Aufrollen oder Aufwickeln derselben. Schließlich ist die Matrizenfolie selbst Teil des Systems.

Gemäß einer Variante kann das System weiterhin die zuletzt genannte Prägefolie sowie eine Vorrichtung zum Zuführen der Prägefolie zu der Endloslaminierpresse und gegebenenfalls eine Vorrichtung zum Aufrollen der Prägefolie am Ende des Endloslaminierprozesses umfassen.

Im Folgenden wird die Erfindung mit Bezug auf die beiliegenden Zeichnungen beispielhaft beschrieben. Darin zeigen:
- Figur 1: schematisch ein System zum Herstellen eines Modulstreifens und
- Figur 2: einen Ausschnitt eines mittels des Systems aus Figur 1 hergestellten Modulstreifens im Querschnitt während der Herstellung.

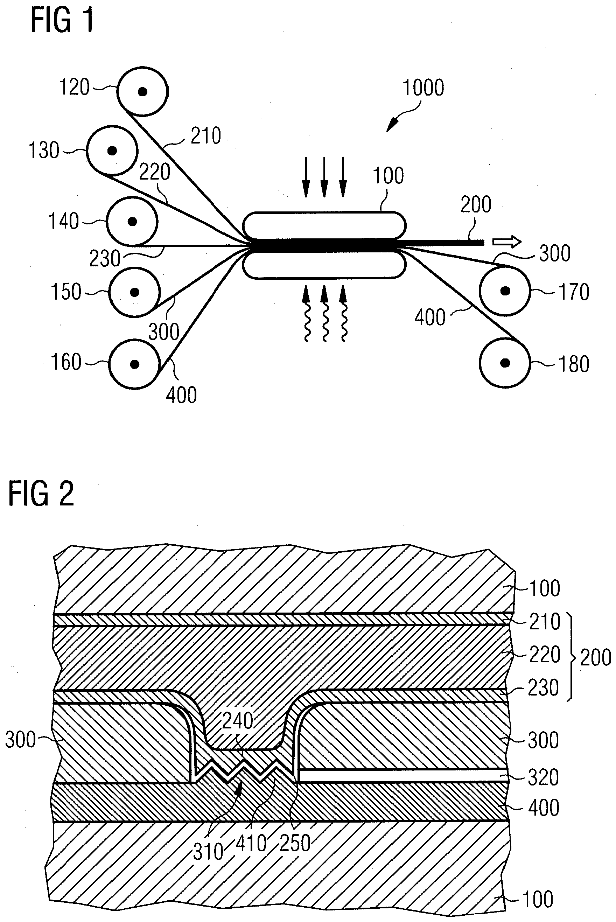

Wie in Figur 1 schematisch dargestellt, umfasst ein System 1000 zum Herstellen eines Modulstreifens 200 mit Erhebungen 240 (vgl. Fig. 2) in einer auf einer Seite des Modulstreifens 200 angeordneten elektrisch leitfähigen Schicht 230 eine Endloslaminierpresse 100 sowie verschiedene Vorrichtungen 120, 130, 140 zum Zuführen von Materialschichten 210, 220, 230 und Vorrichtungen 150, 160; 170, 180 zum Zuführen und zum Wiederaufrollen von verschiedenen Folien 300, 400, welche im Rahmen des Herstellungsprozesses benötigt werden.

Die Vorrichtungen 120,130, 140, 150, 160 zum Zuführen der Materialbahnen 210, 220, 230 sowie der nachstehend genauer beschriebenen Folien 300, 400 sind in der Regel in Form von Rollen oder dergleichen ausgeführt, genauso die Vorrichtungen 170, 180 zum Wiederaufrollen der Folien.

Teil des Systems 1000 sind weiterhin die nachstehend im Detail beschriebene Matrizenfolie 300 sowie eine ebenfalls nachstehend beschriebene Prägefolie 400.

Über die Vorrichtungen 120, 130, 140 werden eine erste elektrisch leitfähige Schicht 210, eine Kunststoffträgerschicht 220 sowie eine zweite elektrisch leitfähige Schicht 230 der Endloslaminierpresse 100 zugeführt, um dort unter Einwirkung von Druck (dargestellt durch die geraden Pfeile) und Wärme (dargestellt durch die gewellten Pfeile) zu dem Modulstreifen 200 verbunden zu werden.

Die elektrisch leitfähigen Schichten 210, 230 werden dabei vorzugsweise jeweils in Form einer Kupferschicht bereitgestellt. Die erste elektrisch leitfähige Schicht 210 ist dabei optional.

Die Trägerschicht 220 wird, wie bereits angedeutet, vorzugsweise in Form einer Kunststoffschicht der Endloslaminierpresse 100 zugeführt. Beim Zuführen liegt die Kunststoffschicht 220 in einem noch nicht vollständig ausgehärteten oder noch nicht vollständig vernetzten Zustand vor. Die Aushärtung bzw. Vernetzung erfolgt erst unter der Einwirkung von Wärme in der Endloslaminierpresse 100. Mit anderen Worten ist die Kunststoffträgerschicht 220 im Laufe des Laminierverfahrens noch verformbar. Als Kunststoffträgerschicht 220 kann insbesondere ein so genanntes "prepreg", d.h. ein faserverstärktes, vorzugsweise duroplastisches Kunststoffhalbzeug, verwendet werden.

Um in der zweiten elektrisch leitfähigen Schicht 230 Erhebungen 240 auszubilden, wird der Endloslaminierpresse 100, welche den Modulstreifen 200 in einem kontinuierlichen Prozess, d.h. in einem Endlosprozess, erzeugt, weiterhin die Matrizenfolie 300 zugeführt.

Die Matrizenfolie 300 ist, wie mit Bezug auf Figur 2 dargestellt, mit Aussparungen 310 versehen. Beim Verbinden der Trägerschicht 220 mit der zweiten elektrisch leitfähigen Schicht 230 zu dem Modulstreifen 200 werden die elektrisch leitfähige Schicht 230 und Teile der Trägerschicht 220 durch den in der Endloslaminierpresse 100 vorherrschenden Druck in die Aussparungen 310 eingepresst, wodurch sich Erhebungen 240 in der zweiten elektrisch leitfähigen Schicht 230 ergeben.

Die Aussparungen 310 werden vorzugsweise als die Matrizenfolie 300 vollständig durchsetzende Durchgangsöffnungen vorgesehen. Die Tiefe der Aussparungen 310 ist dabei durch die Dicke der Matrizenfolie 300 vorgegeben. Eine solche Dicke bestimmt damit die maximale Höhe der Erhebungen 240 und beträgt vorzugsweise nicht mehr als 150 µm. Davon abweichende Schichtdicken sind ebenfalls möglich, abhängig von der Höhe, welche die Erhebungen 240 in der zweiten elektrisch leitfähigen Schicht 230 des Modulstreifens 200 erhalten sollen.

Auch mittels des Durchmessers der Aussparungen 310 in der Matrizenfolie 300 kann, bei gleichbleibendem Druck in der Endloslaminierpresse 100, eine Höhe der Erhebungen 240 mitbestimmt werden. Bei gleichem Druck können geringere Durchmesser zu weniger ausgeprägten Erhebungen 240 führen.

Entlüftungskanäle 320, welche in der Matrizenfolie 300 auf der dem Modulstreifen 200 gegenüberliegenden Seite vorgesehen sind, dienen dazu, beim Einpressen der elektrisch leitfähigen Schicht 230 in die Aussparungen 310 der Matrizenfolie 300 aus den Aussparungen 310 entweichende Luft abzuleiten. Vorzugsweise beträgt die Tiefe und Breite dieser Entlüftungskanäle 320 nicht mehr als 20 µm.

Um eine gute und zuverlässige Entlüftung während des Herstellungsprozesses sicherstellen zu können, sind verschiedene Entlüftungskanäle 320 miteinander verbunden. Die Entlüftungskanäle können beispielsweise gitterförmig - vorzugsweise über die gesamte Oberfläche der Matrizenfolie und zum Rand derselben hin - angeordnet sein. Weiterhin ist jede der Aussparungen 310 vorzugsweise mit mehreren Entlüftungskanälen 320 verbunden.

Die Prägefolie 400 dient dazu, den Erhebungen 240 in der zweiten elektrisch leitfähigen Schicht 230 des Modulstreifens 200 eine zusätzliche räumliche Struktur 250 einzuprägen. Dazu umfasst die Prägefolie 400 in dem Bereich, in dem die Matrizenfolie 300 Aussparungen 310 aufweist, eine Prägestruktur 410. Wenn die Kunststoffträgerschicht 220 und die zweite elektrisch leitfähige Schicht 230, wie in Figur 2 gezeigt, im Rahmen des Endloslaminierprozesses durch den Druck in der Endloslaminierpresse 100 in die Aussparungen 310 der Matrizenfolie 300 gepresst werden, wird der zweiten elektrisch leitfähigen Schicht 230 mittels der im Bereich der Aussparungen 310 vorliegenden Prägestruktur 410 der Prägefolie eine räumliche Struktur 250 eingeprägt.

Die Prägefolie 400 kann alternativ auch durchgehend mit der Prägestruktur versehen sein, so dass eine getaktete Förderung der Prägefolie 400 relativ zur Matrizenfolie 300 unnötig wird. Es ist dann lediglich darauf zu achten, dass die leitfähige Schicht 230 tief genug in die Aussparungen 310 der Matrizenfolie 300 eingedrückt wird, um noch von der darunter angeordneten Prägefolie 400 geprägt zu werden.

Die Prägefolie 400 und/oder die Matrizenfolie 300 werden vorzugsweise als Metallfolien, beispielsweise in Form von Messing- oder Kupferfolien hinreichender Dicke, bereitgestellt.

Die räumliche Strukturierung kann diesen Folien 300, 400 mittels bekannter Verfahren beigebracht werden, beispielsweise mittels Ätzen, Fräsen, Lasern etc.

## Patentansprüche

1. Verfahren zum Herstellen eines Modulstreifens (200) mit Erhebungen (240) in einer auf einer Seite des Modulstreifens (200) angeordneten elektrisch leitfähigen Schicht (230), umfassend die Schritte:
- Bereitstellen einer Trägerschicht (220) und zumindest einer elektrisch leitfähigen Schicht (230);
- Bereitstellen einer Matrizenfolie (300), in welcher Aussparungen (310) ausgebildet sind, wobei die Aussparungen (310) als Durchgangslöcher ausgebildet sind;
- Bereitstellen einer Prägefolie (400), die eine räumliche Prägestruktur (410) aufweist,
- Verbinden der Trägerschicht (220) mit der elektrisch leitfähigen Schicht (230) zu dem Modulstreifen (200) in der Endloslaminierpresse (100) in einem kontinuierlichen Prozess, wobei die elektrisch leitfähige Schicht (230) in die Aussparungen (310) der Matrizenfolie (300) gepresst wird,
- Zuführen der Matrizenfolie (300) zusammen mit der Trägerschicht (220), der Prägefolie (400) und der elektrisch leitfähigen Schicht (230) zu einer Endloslaminierpresse (100), wobei die elektrisch leitfähige Schicht (230) zwischen der Matrizenfolie (300) und der Trägerschicht (220) angeordnet wird und die Prägefolie (400) als äußere Lage benachbart zu der Matrizenfolie (300) angeordnet wird und im Bereich der Aussparungen (310) der Matrizenfolie (300) derart strukturiert ist, dass der in die Aussparungen (310) der Matrizenfolie (300) gepressten elektrisch leitfähige Schicht (230) im Bereich der Spitzen der Erhebungen (240) eine räumliche Struktur (250) eingeprägt wird.

2. Verfahren nach Anspruch 1, **dadurch gekennzeichnet, dass** die Prägefolie (400) in Form einer Metallfolie bereitgestellt wird.

3. Verfahren nach Anspruch 2, **dadurch gekennzeichnet, dass** als Metallfolie eine Kupfer- oder Messingfolie verwendet wird.

4. Verfahren nach einem der vorhergehenden Ansprüche, **dadurch gekennzeichnet, dass** die Matrizenfolie (300) der Endloslaminierpresse (100) in Form einer Endlosbahn zugeführt wird.

5. Verfahren nach einem der vorhergehenden Ansprüche, **dadurch gekennzeichnet, dass** die Matrizenfolie (300), nachdem sie die Endloslaminierpresse (100) verlassen hat, aufgerollt wird.

6. Verfahren nach einem der vorhergehenden Ansprüche, **dadurch gekennzeichnet, dass** die Trägerschicht (220) in Form eines noch nicht vollständig ausgehärteten Kunststoffs, insbesondere eines noch nicht vollständig vernetzten Kunststoffs, bereitgestellt wird.

7. Verfahren nach Anspruch 6, **dadurch gekennzeichnet, dass** als Kunststoff ein faserverstärkter Kunststoff bereitgestellt wird.

8. Verfahren nach einem der vorhergehenden Ansprüche, **dadurch gekennzeichnet, dass** die elektrisch leitfähige Schicht (230) in Form einer Kupferschicht bereitgestellt wird.

9. Verfahren nach einem der vorhergehenden Ansprüche, **dadurch gekennzeichnet, dass** die Matrizenfolie (300) in Form einer Metallfolie bereitgestellt wird.

10. Verfahren nach Anspruch 9, **dadurch gekennzeichnet, dass** als Metallfolie eine Kupfer- oder Messingfolie verwendet wird.

11. Verfahren nach einem der vorhergehenden Ansprüche, **dadurch gekennzeichnet, dass** die Matrizenfolie (300) eine Dicke von höchstens 150 µm aufweist.

12. Verfahren nach einem der vorhergehenden Ansprüche, **dadurch gekennzeichnet, dass** beim Einpressen der elektrisch leitfähigen Schicht (230) in die Aussparungen (310) der Matrizenfolie (300) aus den Aussparungen (310) entweichende Luft über mit den Aussparungen (310) verbundene Entlüftungskanäle (320) der Matrizenfolie (300) abgeleitet wird.

13. Verfahren nach einem der vorhergehenden Ansprüche, **dadurch gekennzeichnet, dass** der Endloslaminierpresse (100) eine weitere elektrisch leitfähige Schicht (210) zugeführt wird, wobei die elektrisch leitfähige Schicht (230) und die weitere elektrisch leitfähige Schicht (210) auf gegenüberliegenden Seiten der Trägerschicht (220) angeordnet werden und sich beide in der Endloslaminierpresse mit der Trägerschicht (220) zu dem Modulstreifen (200) verbinden.

## Claims

1. A method for manufacturing a module strip (200) having elevations (240) in an electrically conductive layer (230) arranged on one side of the module strip (200), comprising the steps of:
- providing a carrier layer (220) and at least one electrically conductive layer (230);
- providing a matrix foil (300) in which recesses (310) are formed, wherein the recesses (310) are configured as through holes;
- providing an embossing foil (400) which has a spatial embossing structure (410),
- connecting the carrier layer (220) with the electrically conductive layer (230) into the module strip (200) in the endless laminating press (100) in a continuous process, wherein the electrically conductive layer (230) is pressed into the recesses (310) of the matrix foil (300),
- feeding the matrix foil (300) together with the carrier layer (220), the embossing foil (400) and the electrically conductive layer (230) to an endless laminating press (100), wherein the electrically conductive layer (230) is arranged between the matrix foil (300) and the carrier layer (220) and the embossing foil (400) is arranged as an outer layer adjacent to the matrix foil (300) and is structured in the region of the recesses (310) of the matrix foil (300) in such a way that a spatial structure (250) is embossed into the electrically conductive layer (230) pressed into the recesses (310) of the matrix foil (300) in the region of the peaks of the elevations (240).

2. The method according to claim 1, **characterized in that** the embossing foil (400) is provided in the form of a metal foil.

3. The method according to claim 2, **characterized in that** a copper or brass foil is used as metal foil.

4. The method according to any of the preceding claims, **characterized in that** the matrix foil (300) is fed to the endless laminating press (100) in the form of an endless web.

5. The method according to any of the preceding claims, **characterized in that** the matrix foil (300) is rolled up after it has left the endless laminating press (100).

6. The method according to any of the preceding claims, **characterized in that** the carrier layer (220) is provided in the form of a not yet completely cured plastic, in particular a not yet completely cross-linked plastic.

7. The method according to claim 6, **characterized in that** a fibre-reinforced plastic is provided as a plastic.

8. The method according to any of the preceding claims, **characterized in that** the electrically conductive layer (230) is provided in the form of a copper layer.

9. The method according to any of the preceding claims, **characterized in that** the matrix foil (300) is provided in the form of a metal foil.

10. The method according to claim 9, **characterized in that** a copper or brass foil is used as metal foil.

11. The method according to any of the preceding claims, **characterized in that** the matrix foil (300) has a thickness of at most 150 µm.

12. The method according to any of the preceding claims, **characterized in that** during pressing the electrically conductive layer (230) into the recesses (310) of the matrix foil (300), air escaping from the recesses (310) is conducted away via vent channels (320) of the matrix foil (300), which vent channels are connected to the recesses (310).

13. The method according to any of the preceding claims, **characterized in that** a further electrically conductive layer (210) is fed to the endless laminating press (100), wherein the electrically conductive layer (230) and the further electrically conductive layer (210) are arranged on opposite sides of the carrier layer (220) and both connect with the carrier layer (220) into the module strip (200) in the endless laminating press.

## Revendications

1. Procédé de fabrication d'un ruban de module (200) ayant des protubérances (240) dans une couche (230) électriquement conductrice agencée sur une face du ruban de module (200), comportant les étapes :
- mise à disposition d'une couche support (220) et d'au moins une couche (230) électriquement conductrice ;
- mise à disposition d'une feuille matrice (300) dans laquelle des évidements (310) sont réalisés, cependant que les évidements (310) sont réalisés sous forme de trous traversants ;
- mise à disposition d'une feuille de gaufrage (400) qui présente une structure de gaufrage (410) spatiale,
- jonction de la couche support (220) et de la couche (230) électriquement conductrice de manière à obtenir le ruban de module (200), dans la presse de laminage sans fin (100) lors d'un processus continu, cependant que la couche (230) électriquement conductrice est pressée dans les évidements (310) de la feuille matrice (300),
- amenée de la feuille matrice (300), en même temps que de la couche support (220), de la feuille de gaufrage (400) et de la couche (230) électriquement conductrice, vers une presse de laminage sans fin (100), cependant que la couche (230) électriquement conductrice est agencée entre la feuille matrice (300) et la couche support (220) et que la feuille de gaufrage (400) est agencée en tant que strate extérieure de manière adjacente à la feuille matrice (300) et est structurée de telle façon dans la zone des évidements (310) de la feuille matrice (300) que, à la couche (230) électriquement conductrice pressée dans les évidements (310) de la feuille matrice (300), une structure spatiale (250) est gaufrée dans la zone des pointes des évidements (240).

2. Procédé selon la revendication 1, **caractérisé en ce que** la feuille de gaufrage (400) est mise à disposition sous forme d'un feuille métallique.

3. Procédé selon la revendication 2, **caractérisé en ce que**, en tant que feuille métallique, une feuille de cuivre ou de laiton est utilisée.

4. Procédé selon une des revendications précédentes, **caractérisé en ce que** la feuille matrice (300) est amenée sous forme d'une bande sans fin à la presse de laminage sans fin (100).

5. Procédé selon une des revendications précédentes, **caractérisé en ce que** la feuille matrice (300) est enroulée après qu'elle a quitté la presse de laminage sans fin (100).

6. Procédé selon une des revendications précédentes, **caractérisé en ce que** la couche support (220) est mise à disposition sous forme d'une matière plastique non encore entièrement durcie, en particulier d'une matière plastique non encore entièrement réticulée.

7. Procédé selon la revendication 6, **caractérisé en ce que**, en tant que matière plastique, une matière plastique renforcée avec des fibres est mise à disposition.

8. Procédé selon une des revendications précédentes, **caractérisé en ce que** la couche (230) électriquement conductrice est mise à disposition sous forme d'une couche de cuivre.

9. Procédé selon une des revendications précédentes, **caractérisé en ce que** la feuille matrice (300) est mise à disposition sous forme d'une feuille métallique.

10. Procédé selon la revendication 9, **caractérisé en ce que**, en tant que feuille métallique, une feuille de cuivre ou de laiton est utilisée.

11. Procédé selon une des revendications précédentes, **caractérisé en ce que** la feuille matrice (300) a une épaisseur d'au maximum 150 µm.

12. Procédé selon une des revendications précédentes, **caractérisé en ce que**, lors du pressage de la couche (230) électriquement conductrice dans les évidements (310) de la feuille matrice (300), de l'air s'échappant des évidements (310) est évacué à travers des canaux de ventilation (320), de la feuille matrice (300), reliés aux évidements (310).

13. Procédé selon une des revendications précédentes, **caractérisé en ce que**, à la presse de laminage sans fin (100), une autre couche (210) électriquement conductrice est acheminée, cependant que la couche (230) électriquement conductrice et l'autre couche (210) électriquement conductrice sont agencées sur des faces opposées de la couche support (220) et que toutes deux se joignent dans la presse de laminage sans fin à la couche support (220) de manière à ce qu'un ruban de module (200) soit obtenu.
